# EUROPEAN PATENT APPLICATION

(11) **EP 4 593 016 A1**
(43) Date of publication of application: **30.07.2025**
(21) Application number: 25151822.1
(22) Date of filing: 14.01.2025
(51) Int. Cl.: G11C 13/00, G11C 7/12

(54) **METHOD OF INITIALIZING BIT LINES IN PHASE CHANGE MEMORIES, CORRESPONDING DEVICE AND COMPUTER PROGRAM PRODUCT**

(30) Priority: 29.01.2024 IT 202400001629
(71) Applicant: STMicroelectronics International N.V., 1228 Plan-les-Ouates, Geneva (CH)
(72) Inventor: TOMAIUOLO, Francesco, 95024 Acireale (Catania) (IT); RUTA, Marco, 95027 San Gregorio di Catania (Catania) (IT); BUONO, Luigi, 95030 Gravina di Catania (Catania) (IT); CONTE, Antonino, 95030 Tremestieri Etneo (Catania) (IT); GRIMAL, Marion Helne, 95121 Catania (IT)
(74) Representative: Buzzi, Notaro & Antonielli d'Oulx S.p.A.

(57) **Abstract**

A method of performing bit line initializations in a Phase Change Memory, PCM device, the PCM device comprising:
a plurality of cells (100) selectable via a plurality of respective bipolar transistors, said plurality of cells (100) being arranged in bit lines and word lines, and
a pair of additional control word lines,
wherein the method comprises:
polarizing the bit lines to a polarization voltage (INT_V), said polarization voltage (INT_V) being higher than a threshold voltage of the plurality of respective transistors;
clamping said bit lines at said threshold voltage via said pair of additional control word lines; and
polarizing the word lines to a reading voltage (VBL), said reading voltage (VBL) being higher than the polarization voltage (INT_V).

## Description

### Technical field

The description relates to the field of data storage technologies.

One or more embodiments can be applied to computer storage technologies such as PCM, that is, Phase Change Memory, for instance, ePCM (that is, embedded Phase Change Memory) and/or ePCM NVM (that is, Non-Volatile Memory ePCM).

### Background

Phase Change Memories, referred to as PCM, are a type of computer storage technology, that is, memory technology and, generally, a type of non-volatile random-access memory technology that may be embedded in integrated circuit (IC) semiconductor devices.

Usually, PCM operates on a bit-by-bit basis since the heat produced by an electric current flowing through a heating material called phase-change material such as, for instance, a chalcogenide glass, is used to melt and quench the phase-change material, making it amorphous, or to hold such phase-change material in its crystallization temperature range, thereby switching it to a crystalline state.

Therefore, a PCM storage unit may use such phase-change material to store 1-bit of information since the two states of the phase-change material, that is, amorphous or crystalline, are characterized by different resistance values that facilitate distinguishing one of the states from the other, that is, each of the two states corresponds to a different value of a single bit.

Thus, the phase-change material can stably exist in two states:
an amorphous or disordered state, characterized by high electrical resistivity, that is, by high resistance, for instance, about 0.6 MΩ, representing, for instance, a low logical state, for instance, '0', characterized by a low current flowing through it, or
a crystalline or ordered state, characterized by low electrical resistivity, that is, by low resistance, for example, a resistance lower than that of the amorphous state, for instance, about 18 kΩ, representing, for instance, a high logical state, for instance, '1', characterized by a high current flowing through it.

For instance, a read operation of a specific cell may be done by testing the resistance value, for instance, through a current pulse, of the phase-change material of the specific cell in order to detect the current phase, that is, amorphous or crystalline, of the phase-change material.

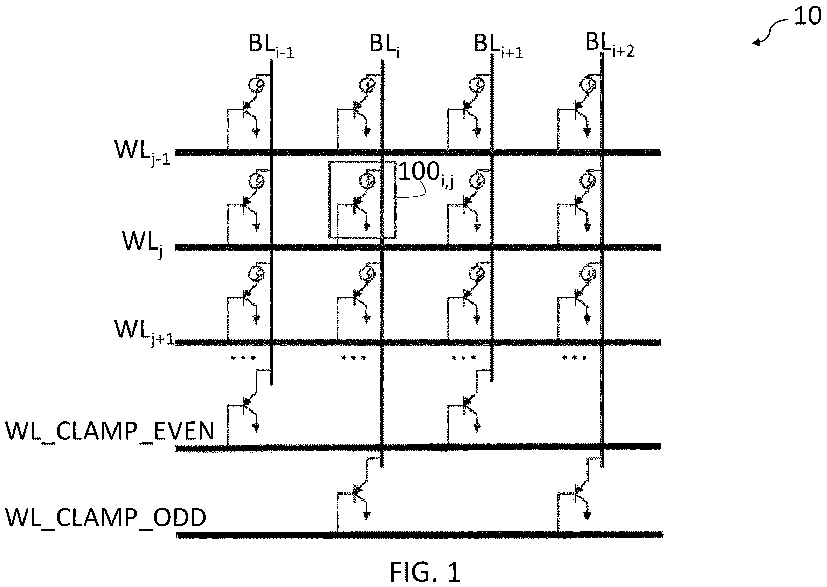

Figure 1 illustrates a typical array structure 10 of a PCM, for instance, PCM NVM, that is, a Non-Volatile Memory PCM, using bipolar transistors as cell selectors.

It is also noted that, even if the following description considers a PCM NVM structure, same conclusions also apply to computer storage technologies such as PCM, that is, Phase Change Memory, ePCM, that is, embedded Phase Change Memory, and/or ePCM NVM, that is, Non-Volatile Memory ePCM.

Such PCM array comprises a plurality of cells, collectively referred to with the reference 100, coupled together.

Such plurality of cells 100 is organized in:
bit lines BLᵢ₋₁, BLᵢ, BLᵢ₊₁, and BLᵢ₊₂, collectively referred to with the reference BL, corresponding to rows of the array structure, and
word lines WLⱼ₋₁, WLⱼ, and WLⱼ₊₁, collectively referred to with the reference WL, corresponding to columns of the array structure.

Each cell in the plurality of cells 100 is coupled to a respective bit line BL and to a respective word line WL.

Each cell in the plurality of cells 100 is coupled to a different pair of lines comprising a bit line BL and a word line WL, so that the respective bit line BL and the respective word line WL to which a given cell is coupled may be considered as coordinates to unambiguously identify such given cell.

For instance, a given cell 100_{i,j}, coupled to a given bit line BLᵢ and to a given word line WLⱼ may be identified by a pair of coordinates (i,j) related to the indexes of the given bit line BLᵢ and of the given word line WLⱼ, respectively.

It is noted that two additional word lines, that is, a clamp even word line WL_CLAMP_EVEN and a clamp odd word line WL_CLAMP_ODD, can be considered in order to clamp the bit lines BL that are adjacent to a selected one, that is, adjacent to the cell that is to be read, at a bipolar threshold voltage V_{Th}, that is, a voltage that is to be applied to a bipolar transistor to make such transistor conductive.

To perform such clamping, the clamp even word line WL_CLAMP_EVEN is coupled, through respective bipolar transistors, to the bit lines BL corresponding, for instance, to even numbers, while the clamp odd word line WL_CLAMP_ODD is coupled, through respective bipolar transistors, to the bit lines BL corresponding, for instance, to odd numbers.

The array structure 10 of Figure 1 is to be polarized in order to perform read operations, for instance, a read operation of a given cell 100_{i,j} comprised therein and coupled to a respective word line WLⱼ and a respective bit line BLᵢ.

In the following description the polarization required for reading the given cell 100_{i,j} is described. It is noted that same conclusions also apply if a different cell is considered as the cell to be read.

The respective word line WLⱼ that is coupled to the given cell 100_{i,j} is grounded in order to switch on, that is, making conductive, a respective bipolar transistor that acts as a selector for the given cell 100_{i,j}.

The respective bit line BLᵢ that is coupled to the given cell 100_{i,j} is polarized to a bit line voltage VBL, such bit line voltage VBL being high enough to:
switch on such respective bipolar transistor that acts as a selector for the given cell 100_{i,j}, and
provide a voltage variation on the storage element of the given cell 100_{i,j} that can allow its reading.

For instance, such bit line voltage VBL may have a value of about 1.6 V (volt).

The clamp even word line WL_CLAMP_EVEN and the clamp odd word line WL_CLAMP_ODD are polarized in order to clamp at the bipolar threshold voltage V_{Th}. for instance, at a value of about 0.6 V, the cells that are adjacent to the selected one, that is, adjacent to the given cell 100_{i,j} that is to be read.

For instance, if the given cell 100_{i,j} is selected, the clamp odd word line WL_CLAMP_ODD is polarized to a voltage having the same value of the bit line voltage VBL, while the clamp even word line WL_CLAMP_EVEN is grounded.

As a result of the clamping, the voltage of the bit lines BL that are adjacent to the respective bit line BLᵢ that is coupled to the given cell 100_{i,j} are limited to a value equal to such bipolar threshold voltage V_{Th}.

It is noted that the bit lines BL that are coupled to the clamp odd word line WL_CLAMP_ODD, except for the respective bit line BLᵢ, are in a floating state.

The other word lines WL, that is, the word lines WL comprised in the array structure 10 except for the respective word line WLⱼ, are polarized to a voltage having the same value of the bit line voltage VBL in order to switch off, that is, making non-conductive, the bipolar transistors comprised therein and acting as selectors.

In this way, the bipolar selectors coupled to the respective bit line BLᵢ have been made non-conductive except for the one that is configured to select the given cell 100_{i,j}, that is, except the one related to the cell that is to be read.

It is noted that the bipolar selector that is configured to select the given cell 100_{i,j} that is to be read is further configured to limit, during the read operation, the discharge of the respective bit line BLᵢ coupled to such given cell 100;,;.

In fact, the voltage of the respective bit line BLᵢ coupled to such given cell 100_{i,j} cannot be discharged, during such read operation, below the bipolar threshold voltage V_{Th} of the bipolar transistor acting as selector for such given cell 100_{i,j}.

If no read operation is to be performed, that is, if the array is in an IDLE state, the array structure 10 of Figure 1 is polarized differently.

The word lines WL are polarized to a voltage having the value of the bit line voltage VBL used during reading operations, for instance, 1.6 V, in order to switch off, that is, making non-conductive, the bipolar transistors comprised therein acting as selectors.

To the same purpose, the clamp even word line WL_CLAMP_EVEN and the clamp odd word line WL_CLAMP_ODD are grounded, that is, are polarized in order to clamp at a voltage having a value equal to the bipolar threshold voltage V_{Th}, for instance, 0.6 V, the bit lines BL.

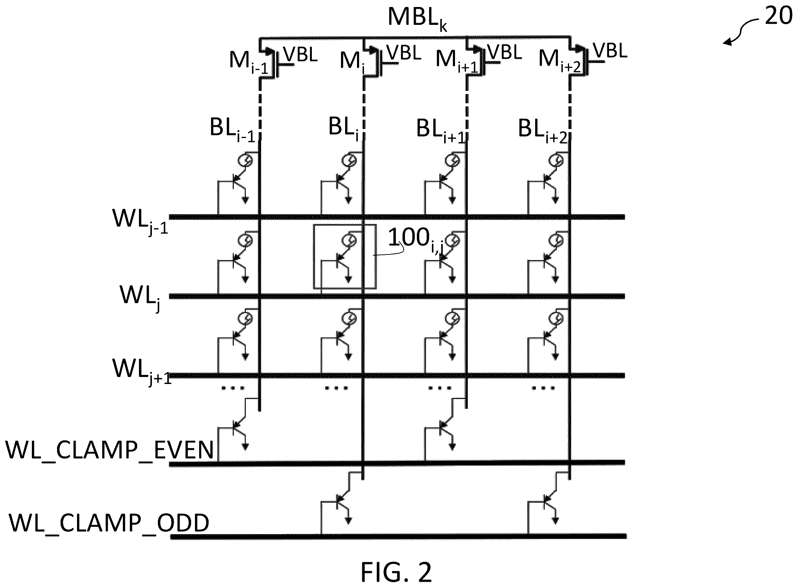

Figure 2 illustrates a decoder coupled to the typical array structure 10 of Figure 1, obtaining a structure 20.

The array structure 10 of Figure 1 may be coupled 20 to a decoding unit, such decoding unit comprising:
a main bit line MBLₖ, that is polarized to a voltage having the value of the bit line voltage VBL used during reading operations, for instance, 1.6 V; and
a plurality of transistors Mᵢ₋₁, Mᵢ, Mᵢ₊₁, and Mᵢ₊₂, collectively referred to as M, for instance, MOSFETs, bipolar transistors, or the like, such plurality of transistors M being configured to couple such main bit line MBLₖ to respective bit lines BL, and to be supplied with respective control terminal voltages (that is, voltages applied to control terminals of such plurality of transistors M, for instance, to gate terminals or base terminals) having different values according to the operation, for instance, read or IDLE, that is to be performed.

During a read operation, the decoder is configured to supply a transistor of the plurality of transistors M with a control terminal voltage having the value of a ground voltage, that is, about 0 V, such transistor being the transistor coupled to a bit line BL that is to be read.

Therefore, such decoder is configured to switch on such transistor coupled to the bit line BL that is to be read by providing a control terminal voltage equal to a ground voltage to the respective control terminal of such transistor.

The decoder is further configured to supply the other transistors of the plurality of transistors M, that is, the transistors that are not coupled to the bit line BL that is to be read, with a control terminal voltage having the value of the bit line voltage VBL used during reading operations, for instance, 1.6 V.

Therefore, such decoder is configured to switch off such transistors different from the transistor coupled to the bit line BL that is to be read by providing a control terminal voltage equal to the bit line voltage VBL to respective control terminals of such transistors.

If no read operation is to be performed, that is, if the array is in an IDLE state, the respective control terminals of the transistors in the plurality of transistors M are supplied with a control terminal voltage having the value of the bit line voltage VBL used during reading operations, for instance, 1.6 V, in order to switch off such plurality of transistors M.

During the IDLE state, the polarization of the bit lines BL obtained by clamping at a voltage having a value equal to the bipolar threshold voltage V_{Th}, for instance, 0.6 V, may be stable.

Such stability may be obtained from:
selector leakage currents BE_{Leak} flowing between control terminals, that is, base terminals, and current supply terminals, that is, emitter terminals, of the bipolar transistors acting as selectors coupled to the word lines WL, and
decoding leakage currents YO_{Leak} coming from the decoder illustrated in Figure 2, such decoding leakage currents YO_{Leak} being obtained as a result of the polarization of the main bit line MBLₖ at the bit line voltage VBL,
that flow through the bipolar transistors acting as selectors coupled to the clamp odd word line WL_CLAMP_ODD and to the clamp even word line WL_CLAMP_EVEN.

As a result of the stable clamping at a voltage having a value equal to the bipolar threshold voltage V_{Th}, for instance, 0.6 V, of the bit lines BL, a read operation following an IDLE state is advantaged in terms of time required for accessing a cell that is to be read 100_{i,j}.

In fact, the respective bit line BLᵢ, that is, the bit line coupled to the cell that is to be read 100_{i,j}, is to be pre-charged starting from the voltage having a value equal to the bipolar threshold voltage V_{Th}, for instance, 0.6 V, up to the voltage having the value of the bit line voltage VBL used during reading operations, for instance, 1.6 V, therefore, filling a smaller gap than a pre-charging operation performed starting from a voltage equal to 0 V up to such voltage having the value of the bit line voltage VBL.

Therefore, starting the pre-charging operation from the voltage having a value equal to the bipolar threshold voltage V_{Th}, for instance, 0.6 V, instead of the voltage equal to 0 V, leads to shorter cells access times during reading operations.

Such shorter cell access time can be relevant, for instance, in PCM NVM with (very) fast access time, for instance, with access times smaller than 10 ns (nanoseconds).

However, in some cases, before a read operation, the bit lines BL may not be polarized at the voltage having a value equal to the bipolar threshold voltage V_{Th}, for instance, each time the main bit line MBLₖ and the word lines WL are discharged to ground or to a voltage close to ground.

Possible examples of cases wherein the main bit line MBLₖ and the word lines WL can be discharged to ground or to a voltage close to ground are cases of power off, standby, stop, and, in general, when the PCM is in low power mode and a regulator used to generate the voltage having the value of the bit line voltage VBL used during reading operations, for instance, 1.6 V, is switched off.

In such cases, when the PCM exits low power mode and the regulator is switched on, the voltage having the value of the bit line voltage VBL used during reading operations is applied to the main bit line MBLₖ and the word lines WL and, in response to the presence of the selector leakage currents BE_{Leak} and decoding leakage currents YO_{Leak}, the bit lines BL are charged, after a time, at the voltage having a value equal to the bipolar threshold voltage V_{Th}.

During that time, depending on process and temperature, the voltage applied to the bit lines BL is lower than the one having a value equal to the bipolar threshold voltage V_{Th}, for instance, of about 0.6 V.

Therefore, during that time, a read operation requires more time, leading to longer access times. In fact, the pre-charging operation, aiming at pre-charging a respective bit line BLᵢ, that is, the bit line coupled to a cell that is to be read 100_{i,j}, up to the voltage having the value of the bit line voltage VBL used during reading operations, for instance, 1.6 V, requires more time.

In fact, the pre-charging operation has to fill a larger gap than the gap between the voltage having a value equal to the bipolar threshold voltage V_{Th}, applied to the bit lines BL after such certain time, and the one having the value of the bit line voltage VBL used during reading operations.

Solutions that facilitate removing the previous limitation, allowing obtaining PCM memories with a reading access time related to the exiting low power mode (or to the power on of the PCM, or the like) and to the switching on of the regulator equal to the reading access time obtained during normal operations of the PCM and the regulator, may be advantageous in order to obtain PCM memories with an improved reading access time.

### Object and summary

An object of one or more embodiments is to contribute in providing such a solution.

According to one or more embodiments, that object is achieved via a method for performing a PCM bit line initialization having the features set forth in the claims that follow.

One or more embodiments concern a corresponding memory device, and a corresponding computer program product loadable in at least one processing circuit (for instance, a computer) and comprising software code portions for executing the steps of the method when the product is run on at least one processing circuit.

As used herein, reference to such a computer program product is understood as being equivalent to reference to a computer-readable medium containing instructions for controlling a processing system in order to co-ordinate implementation of the method according to one or more embodiments.

The claims are an integral part of the technical teaching provided in respect of the embodiments.

Solutions as described herein include a method of performing bit lines initializations in a Phase Change Memory, PCM device.

The PCM device comprises:
a plurality of cells that are selectable via a plurality of respective transistors, for instance, bipolar transistors used as selectors, such plurality of cells being arranged in bit lines and word lines, and
a pair of additional control word lines used to clamp odd and even bit lines.

The method as described herein comprises:
polarizing the bit lines to a first voltage (hereinafter referred to also as polarization voltage), such first/polarization voltage being higher than a threshold voltage related to the plurality of respective transistors;
clamping such bit lines at such threshold voltage via such pair of additional control word lines; and
polarizing the word lines to a reading voltage, such reading voltage being higher than the polarization voltage.

Solutions as described herein facilitate obtaining PCM memories with a reading access time related to the exiting from low power mode (or to the power on of the PCM, or the like) and to the switching on of the regulator equal to the reading access time obtained during normal operations of the PCM and the regulator in order to obtain PCM memories with an improved reading access time.

### Brief description of the figures

One or more embodiments will now be described, by way of example only, with reference to the annexed figures, wherein:
Figure 1, as already described, illustrates a typical array structure of a PCM, for instance, PCM NVM, using bipolar transistors as cell selectors;
Figure 2, as already described, illustrates a decoder coupled to the typical array structure of Figure 1;
Figure 3 illustrates a structure for initializing the bit lines to a given voltage, for instance, a voltage having a value equal to a bipolar threshold voltage, such structure being coupled to an array structure according to embodiments of the present description; and
Figure 4 illustrates an exemplary behavior of the signals flowing in the structure for initializing the bit lines coupled to the array structure according to embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular configurations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

As previously described, solutions as described herein aim at obtaining PCM memories with a reading access time related to the exiting from low power mode (or to the power on of the PCM, or the like) and to the switching on of the regulator equal to the reading access time obtained during normal operations of the PCM and the regulator in order to obtain PCM with an improved reading access time.

Therefore, solutions as described herein are configured to initialize, during a low power mode exit sequence or a power on sequence, the bit lines BL of the array structure 10 to the voltage having a value equal to the bipolar threshold voltage V_{Th}, for instance, of about 0.6 V, in order to apply to such bit lines BL a desired voltage before any read operation that is performed after low power mode or power on.

Such initialization of the bit lines BL is performed without impacting low power mode exit time or power on time, for instance, in parallel to the switch on of some analog blocks.

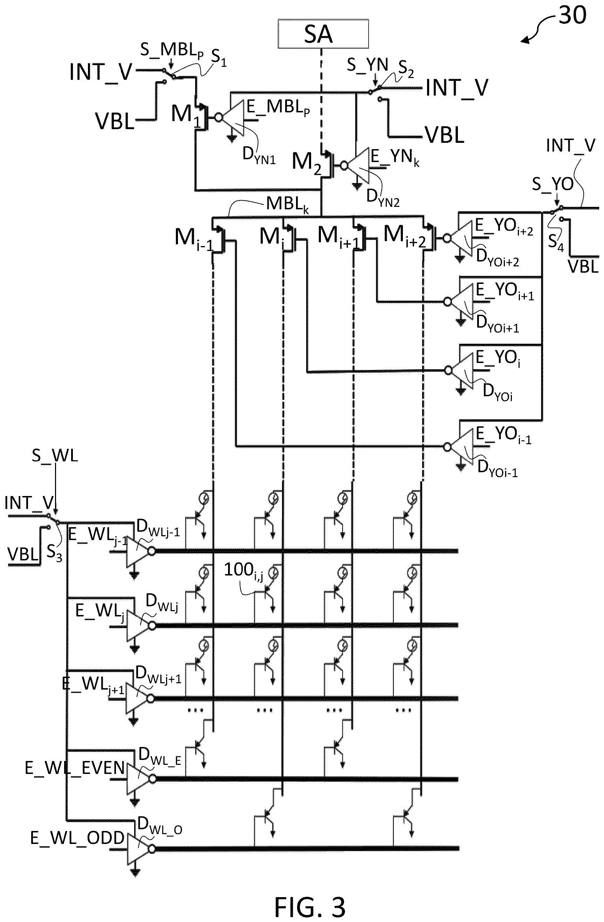

Figure 3 illustrates a structure for initializing the bit lines BL to the desired voltage, that is, the voltage having a value equal to a bipolar threshold voltage V_{Th}, such structure being coupled 30 to an array structure 10, according to embodiments of the present description.

It is noted that a PCM may comprise a plurality of array structures 10 coupled with respective decoding units, such plurality of array structures 10 comprising a plurality of sets of bit lines BL that can be initialized using the structure of Figure 3.

Therefore, even if Figure 3 illustrates a structure for initializing the bit lines BL of a single array structure 10, it is possible to easily adapt such structure for initializing a plurality of sets of bit lines BL comprised in a plurality of array structures 10.

The array structure 10 can be the same as that already described for Figure 1, therefore, a description of such array structure 10 will not be repeated herein in order not to overburden the present description.

The word lines WL, the clamp even word line WL_CLAMP_EVEN, and the clamp odd word line WL_CLAMP_ODD may be coupled to respective word line drivers D_{WLj-1}, D_{WLj}, D_{WLj+1}, D_{WL_E}, and D_{WL_O}, collectively referred to as D_{WL}.

Such word line drivers D_{WL} may be configured to receive, via respective enabling terminals, respective word line enabling signals E_WLⱼ₋₁, E_WLⱼ, E_WLⱼ₊₁, E_WL_EVEN, and E_WL_ODD, collectively referred to as E_WL, such word line enabling signals E_WL being used to enable respective word line drivers D_{WL}.

Such word line drivers D_{WL} may be configured to receive, via respective supplying terminals, respective word line voltages used to polarize such word lines WL, for instance, either the voltage having the value of the bit line voltage VBL used during reading operations, for instance, of about 1.6 V, or a polarization voltage INT_V, for instance, of about 1V.

For instance, the selection between the voltage having the value of the bit line voltage VBL used during reading operations and the polarization voltage INT_V may be done via a word line switch S₃, such word line switch S₃ being controlled with a word line switch control signal S_WL.

Therefore, the word line switch S₃ may be configured:
to couple a terminal supplied with such voltage having the value of the bit line voltage VBL used during reading operations with the word line drivers D_{WL} in response to such word line switch control signal S_WL indicating to supply the word line drivers D_{WL} with the voltage having the value of the bit line voltage VBL; and
to couple a terminal supplied with such polarization voltage INT_V with the word line drivers D_{WL} in response to such word line switch control signal S_WL indicating to supply the word line drivers D_{WL} with the polarization voltage INT_V.

The decoding unit comprising the main bit line MBLₖ and the plurality of transistors Mᵢ₋₁, Mᵢ, Mᵢ₊₁, and Mᵢ₊₂, collectively referred to as M, can be the same as that already described for Figure 2, therefore, a description of such decoding unit will not be repeated herein in order not to overburden the present description.

The plurality of transistors M may be configured to be driven, that is, through respective control terminals, via a plurality of decoding drivers D_{YOi-1}, D_{YOi}, D_{YOi+1}, and D_{YOi+2}, collectively referred to as D_{YO}.

Such decoding drivers D_{YO} may be configured to receive, via respective enabling terminal, respective decoding enabling signals E_YOᵢ₋₁, E_YOᵢ, E_YOᵢ₊₁, and E_YOᵢ₊₂, collectively referred to as E_YO, such decoding enabling signals E_YO being used to enable respective decoding drivers D_{YO}.

Such decoding drivers D_{YO} may be configured to receive, via respective supplying terminal, respective decoding voltages used to control such plurality of transistors M via their control terminals, for instance, gate terminals.

Such respective decoding voltages being, for instance, either the voltage having the value of the bit line voltage VBL used during reading operations, for instance, of about 1.6 V, or the polarization voltage INT_V, for instance, of about 1 V.

For instance, the selection between the voltage having the value of the bit line voltage VBL used during reading operations and the polarization voltage INT_V may be done via a decoding switch S₄, such decoding switch S₄ being controlled with a decoding switch control signal S_YO.

Therefore, the decoding switch S₄ may be configured:
to couple the terminal supplied with such voltage having the value of the bit line voltage VBL used during reading operations with the decoding drivers D_{YO} in response to such decoding switch control signal S_YO indicating to supply the decoding drivers D_{YO} with the voltage having the value of the bit line voltage VBL; and
to couple the terminal supplied with such polarization voltage INT_V with the decoding drivers D_{YO} in response to such decoding switch control signal S_YO indicating to supply the decoding drivers D_{YO} with the polarization voltage INT_V.

The main bit line MBLₖ of the decoding unit may be coupled to:
a first transistor M₁, for instance, a MOSFET, via its current sink terminal, for instance, its drain terminal; and
a second transistor M₂, for instance, a MOSFET, via its current sink terminal, for instance, its drain terminal.

It is noted that, even if in the following description the first transistor M₁ and the second transistor M₂ are implemented using MOSFETs, it is possible to consider equivalent structures using other types of transistors, for instance, other FETs, bipolar transistors, or the like.

The first transistor M₁ may have its current supply terminal, that is, its source terminal, coupled to a first transistor switch S₁, such first transistor switch S₁ being configured to couple such current supply terminal of the first transistor M₁ to either the terminal supplied with such voltage having the value of the bit line voltage VBL used during reading operations or the terminal supplied with such polarization voltage INT_V.

Such coupling may be provided as a function of a first transistor switch control signal S_MBL_{P}, such first transistor switch S₁ being configured:
to couple such current supply terminal to the terminal supplied with such voltage having the value of the bit line voltage VBL in response to such first transistor switch control signal S_MBL_{P} indicating to supply the current supply terminal of the first transistor M₁ with the voltage having the value of the bit line voltage VBL; and
to couple such current supply terminal to the terminal supplied with such polarization voltage INT_V in response to such first transistor switch control signal S_MBL_{P} indicating to supply the current supply terminal of the first transistor M₁ with the polarization voltage INT_V.

The second transistor M₂ may have its current supply terminal, that is, its source terminal, coupled to a sense amplifier SA.

Both the first transistor M₁ and the second transistor M₂ may have their respective control terminals, that is, their respective gate terminals, coupled to respective transistor drivers, that is, to a first transistor driver D_{YN1} and a second transistor driver D_{YN2} respectively, collectively referred to as D_{YN}.

Such transistor drivers D_{YN} may be configured to receive, via respective enabling terminals, a first transistor enabling signal E_MBLₚ and a second transistor enabling signal E_YNₖ respectively, such first transistor enabling signal E_MBLₚ being used to enable the first transistor driver D_{YN1} and such second transistor enabling signal E_YNₖ being used to enable the second transistor driver D_{YN2}.

Such transistor drivers D_{YN} may be configured to receive, via respective supplying terminals, respective transistor voltages used to control the first transistor M₁ and the second transistor M₂ via their control terminals, for instance, gate terminals.

Such respective transistor voltages being, for instance, either the voltage having the value of the bit line voltage VBL used during reading operations, for instance, of about 1.6 V, or the polarization voltage INT_V, for instance, of about 1 V.

For instance, the selection between the voltage having the value of the bit line voltage VBL used during reading operations and the polarization voltage INT_V may be done via a transistor switch S₂, such transistor switch S₂ being controlled with a transistor switch control signal S_YN.

Therefore, the transistor switch S₂ may be configured:
to couple the terminal supplied with such voltage having the value of the bit line voltage VBL used during reading operations with the transistor drivers D_{YN} in response to such transistor switch control signal S_YN indicating to supply the transistor drivers D_{YN} with the voltage having the value of the bit line voltage VBL; and
to couple the terminal supplied with such polarization voltage INT_V with the transistor drivers D_{YN} in response to such transistor switch control signal S_YN indicating to supply the transistor drivers D_{YN} with the polarization voltage INT_V.

Therefore, in response to a request for a power on of the PCM, the PCM exiting low power mode, the switching on of the regulator configured to generate the voltage having the value of the bit line voltage VBL used during reading operations, and/or the like, the main bit line MBLₖ comprised in the decoding unit may be coupled, via the first transistor M₁, to the polarization voltage INT_V.

It is noted that the first transistor switch S₁, the (second) transistor switch S₂, the word line switch S₃, and the decoding switch S₄, may be substituted with a single switch driven by a single control signal, such single switch being supplied with a voltage equal to either the polarization voltage INT_V or the bit line voltage VBL and being configured to couple respectively coupled terminals (that are, the terminals coupled to the previous switches - S 1, S2, S3, and S4 - now coupled to the single switch) with such voltage equal to either the polarization voltage INT_V or the bit line voltage VBL.

Therefore, such single switch may be coupled between a first terminal supplied with the voltage equal to either the polarization voltage INT_V or the bit line voltage VBL, and a second terminal coupled to the current supply terminal of the first transistor M1, the transistor drivers D_{YN}, the word line drivers D_{WL}, and the decoding drivers D_{YO}.

It is noted that the logic levels considered in the following are reported by way of example only and are not intended to limit the scope of protection of the present application, therefore, such logic levels may also be different, for instance, it is possible to switch low logic levels with high logic levels and vice versa.

The coupling of the main bit line MBLₖ to the polarization voltage INT_V, allowing to polarize such main bit line MBLₖ to the polarization voltage INT_V, may be performed by:
setting the first transistor switch control signal S_MBL_{P}, for instance, to a high logic level, in order to indicate to the first transistor switch S₁ to couple the current supply terminal of the first transistor M₁, that is, its source terminal, to the terminal supplied with such polarization voltage INT_V;
setting the transistor switch control signal S_YN, for instance, to a high logic level, in order to indicate to the transistor switch S₂ to couple the terminal supplied with such polarization voltage INT_V to the transistor drivers D_{YN}, such transistor drivers D_{YN} being configured to drive the first transistor M₁ and the second transistor M₂ through their respective control terminals, that is, their respective gate terminals;
setting the second transistor enabling signal E_YNₖ, for instance, to a low logic level, in order to disable the second transistor driver D_{YN2} used to drive the second transistor M₂, thus, disabling such second transistor M₂, that is, making such second transistor M₂ non-conductive; and
setting the first transistor enabling signal E_MBLₚ, for instance, to a high logic level, in order to enable the first transistor driver D_{YN1} used to drive the first transistor M₁, thus, enabling such first transistor M₁, that is, making such first transistor M₁ conductive.

In addition, the bipolar transistors acting as cell selectors coupled to the word lines WL, the clamp even word line WL_CLAMP_EVEN, and the clamp odd word line WL_CLAMP_ODD may be switched off, that is, may be made non-conductive, for instance, by:
setting the word line switch control signal S_WL, for instance, to a high logic level, in order to indicate to the word line switch S₃ to couple the terminal supplied with such polarization voltage INT_V to the word line drivers D_{WL}, such word line drivers D_{WL} being configured to drive such word lines WL, the clamp even word line WL_CLAMP_EVEN, and the clamp odd word line WL_CLAMP_ODD; and
setting the word line enabling signals E_WL, for instance, to a low logic level, in order to disable the word line drivers D_{WL} used to drive such word lines WL, the clamp even word line WL_CLAMP_EVEN, and the clamp odd word line WL_CLAMP_ODD.

In such a way, each of the word lines WL, the clamp even word line WL_CLAMP_EVEN, and the clamp odd word line WL_CLAMP_ODD can be polarized to the polarization voltage INT_V.

Furthermore, the plurality of transistors M comprised in the decoding unit may be switched on, that is, may be made conductive, for instance, by:
setting the decoding switch control signal S_YO, for instance, to a high logic level, in order to indicate to the decoding switch S₄ to couple the terminal supplied with such polarization voltage INT_V to the decoding drivers D_{YO}, such decoding drivers D_{YO} being configured to drive the plurality of transistors M through their respective control terminals, that is, their respective gate terminals; and
setting the decoding enabling signals E_YO, for instance, to a high logic level, in order to enable the decoding drivers D_{YO} used to drive the plurality of transistors M, thus, enabling such plurality of transistors M, that is, making such plurality of transistors M conductive.

In such a way, the bit lines BL of the array structure 10 can be coupled to the main bit line MBLₖ, thus, such bit lines BL can be polarized to the polarization voltage INT_V.

Therefore, after the previously described operations, the bit lines BL of the array structure 10 are initialized to the polarization voltage INT_V.

Then, the plurality of transistors M comprised in the decoding unit may be switched off, that is, may be made non-conductive, for instance, by:
setting the decoding switch control signal S_YO, for instance, to a high logic level, in order to indicate to the decoding switch S₄ to couple the terminal supplied with such polarization voltage INT_V to the decoding drivers D_{YO}, such decoding drivers D_{YO} being configured to drive the plurality of transistors M through their respective control terminals, that is, their respective gate terminals; and
setting the decoding enabling signals E_YO, for instance, to a low logic level, in order to disable the decoding drivers D_{YO} used to drive the plurality of transistors M, thus, disabling such plurality of transistors M, that is, making such plurality of transistors M non-conductive.

In such a way, the bit lines BL of the array structure 10 can be decoupled from the main bit line MBLₖ, which is polarized to the polarization voltage INT_V.

In response to the switching off of the plurality of transistors M, the bipolar transistors acting as cell selectors coupled to the clamp even word line WL_CLAMP_EVEN and the clamp odd word line WL_CLAMP_ODD may be switched on, that is, may be made conductive, for instance, by:
setting the word line switch control signal S_WL, for instance, to a high logic level, in order to indicate to the word line switch S₃ to couple the terminal supplied with such polarization voltage INT_V to the word line drivers D_{WL}, such word line drivers D_{WL} being configured to drive such word lines WL, the clamp even word line WL_CLAMP_EVEN, and the clamp odd word line WL_CLAMP_ODD;
setting the word line enabling signals E_WL related to the word lines WL, that is, the word line enabling signals E_WLⱼ₋₁, E_WLⱼ, and E_WLⱼ₊₁, for instance, to a low logic level, in order to disable the word line drivers D_{WL} used to drive such word lines WL, that is, the word line drivers D_{WLj-1}, D_{WLj}, and D_{WLj+1}; and
setting the word line enabling signals E_WL related to the clamp even word line WL_CLAMP_EVEN and the clamp odd word line WL_CLAMP_ODD, that is, the word line enabling signals E_WL_EVEN and E_WL_ODD, for instance, to a high logic level, in order to enable the word line drivers D_{WL} used to drive such clamp even word line WL_CLAMP_EVEN and such clamp odd word line WL_CLAMP_ODD, that is, the word line drivers D_{WL_E} and D_{WL_O}.

In such a way, each of the word lines WL can be polarized to the polarization voltage INT_V, while the clamp even word line WL_CLAMP_EVEN and the clamp odd word line WL_CLAMP_ODD can be grounded, for instance, at a ground voltage of about 0 V.

In response to the switching on of the clamp even word line WL_CLAMP_EVEN and the clamp odd word line WL_CLAMP_ODD, the bit lines BL of the array structure 10 can be clamped at the bipolar threshold voltage V_{Th}, for instance, at a value of about 0.6 V, which is the desired voltage to be applied to the bit lines BL before any read operation, therefore, such bit lines BL are initialized to the voltage having a value equal to the bipolar threshold voltage V_{Th}.

After such initialization of the bit lines BL, the switches may be configured to switch from the terminal supplied with such polarization voltage INT_V, used during such initialization, to the terminal supplied with the voltage having the value of the bit line voltage VBL, used during normal operations of the PCM, for instance, during reading operations.

Such switching operation may be performed by:
setting the first transistor switch control signal S_MBL_{P}, for instance, to a low logic level, in order to indicate to the first transistor switch S₁ to couple the current supply terminal of the first transistor M₁, that is, its source terminal, to the terminal supplied with the voltage having the value of the bit line voltage VBL used during reading operations;
setting the transistor switch control signal S_YN, for instance, to a low logic level, in order to indicate to the transistor switch S₂ to couple the terminal supplied with the voltage having the value of the bit line voltage VBL used during reading operations to the transistor drivers D_{YN}, such transistor drivers D_{YN} being configured to drive the first transistor M₁ and the second transistor M₂ through their respective control terminals, that is, their respective gate terminals;
setting the word line switch control signal S_WL, for instance, to a low logic level, in order to indicate to the word line switch S₃ to couple the terminal supplied with the voltage having the value of the bit line voltage VBL used during reading operations to the word line drivers D_{WL}, such word line drivers D_{WL} being configured to drive such word lines WL, the clamp even word line WL_CLAMP_EVEN, and the clamp odd word line WL_CLAMP_ODD; and
setting the decoding switch control signal S_YO, for instance, to a low logic level, in order to indicate to the decoding switch S₄ to couple the terminal supplied with the voltage having the value of the bit line voltage VBL used during reading operations to the decoding drivers D_{YO}, such decoding drivers D_{YO} being configured to drive the plurality of transistors M through their respective control terminals, that is, their respective gate terminals.

In response to such switching operation, the array structure 10 is ready to perform read operations right after the power on of the PCM, the PCM exiting low power mode, the switching on of the regulator configured to generate the voltage having the value of the bit line voltage VBL used during reading operations, and/or the like, such read operations being characterized by a reading access time that is equal to that of the reading operations performed during the normal operation of the PCM and/or the regulator, therefore, improving the reading access time of such PCM.

In fact, such bit lines BL, such word lines WL, such clamp even word line WL_CLAMP_EVEN, and such clamp odd word line WL_CLAMP_ODD are polarized to the respective desired voltages as described for the IDLE state of the array structure 10, that is:
the bit lines BL are polarized to the voltage having a value equal to the bipolar threshold voltage V_{Th}, for instance, about 0.6 V;
the word lines WL are polarized to the voltage having the value of the bit line voltage VBL used during reading operations, for instance, about 1.6 V; and
the clamp even word line WL_CLAMP_EVEN, and such clamp odd word line WL_CLAMP_ODD are grounded, that is, polarized to a ground voltage of about 0 V.

To summarize, solutions as described herein disclose a method of performing bit line BL initializations in a Phase Change Memory, PCM device, the PCM device comprising:
a plurality of cells 100 selectable via a plurality of respective transistors, for instance, bipolar transistors acting as selectors, such plurality of cells 100 being arranged in bit lines BL and word lines WL, and
a pair of additional control word lines, that is, the clamp even word line WL_CLAMP_EVEN and the clamp odd word line WL_CLAMP_ODD.

Such method comprising:
polarizing the bit lines BL to a polarization voltage INT_V, for instance, of about 1 V, such polarization voltage INT_V being higher than a threshold voltage of the plurality of respective transistors, that is, the voltage having a value equal to the bipolar threshold voltage V_{Th}, for instance, of about 0.6 V;
clamping such bit lines BL at such threshold voltage V_{Th} via such pair of additional control word lines WL_CLAMP_EVEN and WL_CLAMP_ODD, for instance, by grounding such pair of additional control word lines WL_CLAMP_EVEN and WL_CLAMP_ODD; and
polarizing the word lines WL to a reading voltage, that is, the voltage having the value of the bit line voltage VBL used during reading operations, for instance, of about 1.6 V, such reading voltage VBL being higher than the polarization voltage INT_V.

In order to not impact the reading operations and PCM time performance, such method may be performed at:
a power on of the PCM device;
the PCM device exiting a low power mode; and/or
a switching on of a generator, that is, the regulator, of the reading voltage VBL.

Therefore, such method may be preferably performed without impacting execution time of:
such power on of the PCM device;
the PCM device exiting such low power mode; and/or
such switching on of the generator of the reading voltage VBL.

It is noted that such bit lines BL may be coupled to a main bit line MBLₖ via a second plurality of transistors, that is, the plurality of transistors M.

Such second plurality of transistors M may be configured to be driven via respective control terminals, for instance, respective base terminals, by a first plurality of drivers, that is, the decoding drivers D_{YO}, based on a first plurality of driver control signals, that is, the decoding enabling signals E_YO.

Thus, such second plurality of transistors M may be configured to be made conductive by such first plurality of drivers D_{YO} in response to such plurality of driver control signals E_YO indicating to switch on such second plurality of transistors M; and/or
such second plurality of transistors M may be configured to be made non-conductive by such first plurality of drivers D_{YO} in response to such plurality of driver control signals E_YO indicating to switch off such second plurality of transistors M.

Such first plurality of drivers D_{YO} may be configured to be coupled via a decoding switch S₄, for instance, controlled via the decoding switch control signal S_YO, to a first terminal supplied with the polarization voltage INT_V, wherein, preferably, such first plurality of drivers D_{YO} may be configured to be coupled to a second terminal at the reading voltage VBL via the decoding switch S4 in response to such polarizing the word lines WL to the reading voltage VBL.

In addition, in response to such polarizing the word lines WL to the reading voltage VBL, the main bit line MBLₖ may be polarized to such reading voltage VBL.

The operation of polarizing the bit lines BL to the polarization voltage INT_V may comprise:
polarizing the word lines WL to the polarization voltage INT_V;
polarizing the pair of additional control word lines WL_CLAMP_EVEN and WL_CLAMP_ODD to the polarization voltage INT_V;
polarizing the main bit line MBLₖ to the polarization voltage INT_V; and
making such second plurality of transistors M conductive.

The operation of polarizing the main bit line MBLₖ may be, for instance, performed via:
a first transistor M₁ coupled between the main bit line MBLₖ and a first transistor switch S₁, such first transistor M₁ being configured to be driven, via its control terminal, for instance, a gate terminal, by a first transistor driver D_{YN1} based on a first transistor driver control signal, that is, the first transistor enabling signal E_MBL_{P}; and
a second transistor M₂ coupled between the main bit line MBLₖ and a sense amplifier SA, such second transistor M₂ being configured to be driven, via its control terminal, for instance, a gate terminal, by a second transistor driver D_{YN2} based on a second transistor driver control signal, that is, the second transistor enabling signal E_YNₖ.

Thus, such second transistor M₂ may be made non-conductive by such second transistor driver D_{YN2} in response to such second transistor driver control signal E_YNₖ indicating to switch off such second transistor M₂;
such first transistor M₁ may be made conductive by such first transistor driver D_{YN1} in response to such first transistor driver control signal E_MBL_{P} indicating to switch on such first transistor M₁;
if the main bit line MBLₖ is to be polarized to the polarization voltage INT_V, such first transistor driver D_{YN1} and such second transistor driver D_{YN2} may be coupled, via a second transistor switch, that is, the transistor switch S₂, for instance, controlled via the transistor switch control signal S_YN, to the first terminal supplied with such polarization voltage INT_V and such first transistor M₁ may be coupled, via such first transistor switch S₁, to such first terminal supplied with such polarization voltage INT_V; and
if the main bit line MBLₖ is to be polarized to the reading voltage VBL, such first transistor driver D_{YN1} and such second transistor driver D_{YN2} may be coupled, via the second transistor switch S₂, to the second terminal supplied with such reading voltage VBL and such first transistor M₁ may be coupled, via such first transistor switch S₁, to such second terminal supplied with such reading voltage VBL.

The operation of clamping such bit lines BL at such threshold voltage V_{Th} may comprise:
making such second plurality of transistors M non-conductive; and
polarizing such pair of additional control word lines WL_CLAMP_EVEN and WL_CLAMP_ODD to a ground voltage, for instance, of about 0 V.

The operation of polarizing the pair of additional control word lines WL_CLAMP_EVEN and WL_CLAMP_ODD may be performed via a second plurality of drivers, that is, the word line drivers related to the clamp even word line WL_CLAMP_EVEN and the clamp odd word line WL_CLAMP_ODD, D_{WL_E} and D_{WL_O} respectively, based on a second plurality of driver control signals, that is, the word line enabling signals E_WL related to the clamp even word line WL_CLAMP_EVEN and the clamp odd word line WL_CLAMP_ODD, that is, the word line enabling signals E WLEVEN and E_WL_ODD.

It is noted that if the pair of additional control word lines WL_CLAMP_EVEN and WL_CLAMP_ODD is to be polarized to the polarization voltage INT_V, such second plurality of drivers D_{WL_E} and D_{WL_O}:
may be coupled, via a word line switch S₃, for instance, controlled via the word line switch control signal S_WL, to the first terminal supplied with such polarization voltage INT_V, and
may be disabled in response to such second plurality of driver control signals E_WL_EVEN and E_WL_ODD indicating to switch off such pair of additional control word lines WLCLAMP EVEN and WL_CLAMP_ODD; and
if the pair of additional control word lines WL_CLAMP_EVEN and WL_CLAMP_ODD is to be polarized to the ground voltage, such second plurality of drivers D_{WL_E} and D_{WL_O} may be enabled in response to such second plurality of driver control signals E_WL_EVEN and E_WL_ODD indicating to switch on such pair of additional control word lines WL_CLAMP_EVEN and WL_CLAMP_ODD.

The operation of polarizing the word lines WL may be performed via a third plurality of drivers, that is, the word line drivers related to the word lines WL D_{WLj-1}, D_{WLj}, and D_{WLj+1}, based on a third plurality of driver control signals, that is, the word line enabling signals E_WL related to the word lines WL, that is, the word line enabling signals E_WLⱼ₋₁, E_WLⱼ, and E_WLⱼ₊₁.

It is noted that if the word lines WL are to be polarized to the polarization voltage INT_V, such third plurality of drivers D_{WLj-1}, D_{WLj}, and D_{WLj+1}:
may be coupled, via the word line switch S₃, to the first terminal supplied with such polarization voltage INT_V, and
may be disabled in response to such third plurality of driver control signals E_WLⱼ₋₁, E_WLⱼ, and E_WLⱼ₊₁ indicating to switch off such word lines WL; and
if the word lines WL are to be polarized to the reading voltage VBL, such third plurality of drivers D_{WLj-1}, D_{WLj}, and D_{WLj+1}:
   may be coupled, via the word line switch S₃, to the second terminal supplied with such reading voltage VBL, and
   may be disabled in response to such third plurality of driver control signals E_WLⱼ₋₁, E_WLⱼ, and E_WLⱼ₊₁ indicating to switch off such word lines WL.

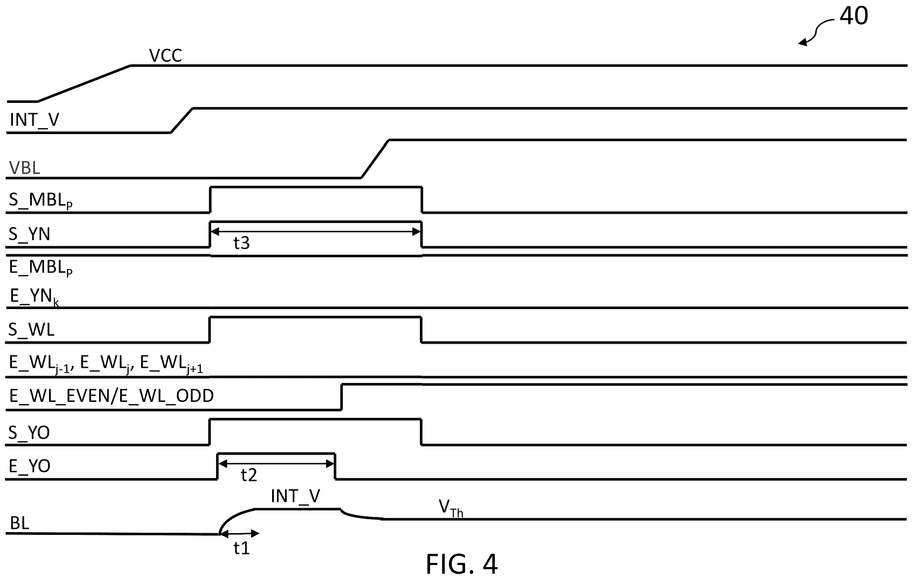

Figure 4 illustrates an exemplary behavior 40 of the signals flowing in the structure for initializing the bit lines BL coupled 30 to the array structure 10 according to embodiments of the present description.

It is noted that the first transistor enabling signal E_MBLₚ may, for instance, for the whole duration of the PCM operations illustrated in Figure 4, be set, for instance, to a high logic level, in order to enable the first transistor driver D_{YN1} used to drive the first transistor M₁, thus, supplying the main bit line MBLₖ during the duration of the PCM operations illustrated in Figure 4.

It is also noted that the second transistor enabling signal E_YNₖ and the word line enabling signals E_WLⱼ₋₁, E_WLⱼ, and E_WLⱼ₊₁, may, for instance, for the whole duration of the PCM operations illustrated in Figure 4, be set, for instance, to a low logic level, in order to disable the second transistor driver D_{YN2} used to drive the second transistor M₂ (making the second transistor M₂ non-conductive during the duration of the PCM operations of Figure 4) and to disable the word line drivers D_{WLj-1}, D_{WLj}, and D_{WLj+1}, (making the word lines WL non-conductive during the duration of the PCM operations of Figure 4) respectively.

In response to a request for a power on of the PCM, the PCM exiting low power mode, the switching on of the regulator configured to generate the voltage having the value of the bit line voltage VBL, and/or the like, a supplying voltage configured to supply one or more circuits comprised in the PCM rises from a value related to the power off, the low power mode, or the like, for instance, from a voltage of about 0 V, to a given voltage VCC.

Therefore, during the power on of the PCM, the PCM exiting low power mode, the switching on of the regulator configured to generate the voltage having the value of the bit line voltage VBL, and/or the like, the polarization voltage INT_V can be generated, such polarization voltage INT_V being used for the initialization of the bit lines BL to the voltage having a value equal to the bipolar threshold voltage V_{Th}.

In response to the generation of the polarization voltage INT_V, the first transistor switch control signal S_MBL_{P}, the transistor switch control signal S_YN, the word line switch control signal S_WL, and the decoding switch control signal S_YO may be set, for instance, to a high logic level, in order to indicate to the respective switch, that is, the first transistor switch S₁, the transistor switch S₂, the word line switch S₃, and the decoding switch S₄, respectively, to be coupled to the terminal supplied with such polarization voltage INT_V.

Then, the decoding enabling signals E_YO may be set, for instance, to a high logic level, in order to enable the decoding drivers D_{YO} used to drive the plurality of transistors M.

In such a way, as previously described, the bit lines BL of the array structure 10 are coupled to the main bit line MBLₖ, therefore, they are charged until the voltage applied thereon reaches the polarization voltage INT_V.

Therefore, after a first time t1, the bit lines BL of the array structure 10 are initialized to the polarization voltage INT_V.

After a second time t2, longer than the first time t1, the decoding enabling signals E_YO may be set, for instance, to a low logic level, in order to disable the decoding drivers D_{YO} used to drive the plurality of transistors M.

In such a way, as previously described, the bit lines BL of the array structure 10 are decoupled from the main bit line MBLₖ.

In response to the bit lines BL of the array structure 10 being decoupled from the main bit line MBLₖ, the word line enabling signals E_WL_EVEN and E_WL_ODD may be set, for instance, to a high logic level, in order to enable the word line drivers D_{WL} used to drive the clamp even word line WL_CLAMP_EVEN and the clamp odd word line WL_CLAMP_ODD, that is, the word line drivers D_{WL_E} and D_{WL_O}.

Therefore, in response to the enabling of the word line drivers D_{WL_E} and D_{WL_O}, the clamp even word line WL_CLAMP_EVEN and the clamp odd word line WL_CLAMP_ODD are grounded, thus, the bit lines BL of the array structure 10 can be clamped at the bipolar threshold voltage V_{Th}, for instance, at a value of about 0.6 V.

Therefore, such bit lines BL are initialized to the voltage having a value equal to the bipolar threshold voltage V_{Th}.

Then, the voltage having the value of the bit line voltage VBL used during reading operations can be generated.

After a third time t3, longer than the second time t2 and corresponding to a moment wherein such bit lines BL are already initialized to the voltage having a value equal to the bipolar threshold voltage V_{Th} and the voltage having the value of the bit line voltage VBL is already generated, the first transistor switch control signal S_MBL_{P}, the transistor switch control signal S_YN, the word line switch control signal S_WL, and the decoding switch control signal S_YO may be set, for instance, to a low logic level, in order to indicate to the respective switch, that is, the first transistor switch S₁, the transistor switch S₂, the word line switch S₃, and the decoding switch S₄, respectively, to be coupled to the terminal supplied with the voltage having the value of the bit line voltage VBL used during reading operations.

Therefore, as previously described, after the coupling of the switches to the terminal supplied with the voltage having the value of the bit line voltage VBL, the array structure 10 is ready to perform read operations, such read operations being characterized by a reading access time that is equal to that of the reading operations performed during the normal operation of the PCM and/or the regulator.

In fact, such bit lines BL, such word lines WL, such clamp even word line WL_CLAMP_EVEN, and such clamp odd word line WL_CLAMP_ODD are polarized to the respective desired voltages as described for the IDLE state of the array structure 10.

Solutions as described herein refers also to a Phase Change Memory, PCM device, the PCM device comprising:
a plurality of cells 100 selectable via a plurality of respective transistors, for instance, bipolar transistors acting as selectors, such plurality of cells 100 being arranged in bit lines BL and word lines WL, and
a pair of additional control word lines, that is, the clamp even word line WL_CLAMP_EVEN and the clamp odd word line WL_CLAMP_ODD;
such PCM device being configured to implement the previously described method.

Solutions as described herein refers also to a computer program product loadable in a control unit of a Phase Change Memory, PCM device, the PCM device comprising:
a plurality of cells 100 selectable via a plurality of respective transistors, for instance, bipolar transistors acting as selectors, such plurality of cells 100 being arranged in bit lines BL and word lines WL, and
a pair of additional control word lines, that is, the clamp even word line WL_CLAMP_EVEN and the clamp odd word line WL_CLAMP_ODD;
the computer program product comprising portions of software code configured to cause the PCM device to implement the previously described method in response to the computer program product being run in the control unit of the PCM device.

Solutions as described herein facilitate achieving a method of performing bit lines initializations in a Phase Change Memory, PCM device, such PCM device comprising:
a plurality of cells that are selectable via a plurality of respective transistors, for instance, bipolar transistors used as selectors, such plurality of cells being arranged in bit lines and word lines, and
a pair of additional control word lines used to clamp odd and even bit lines.

The method as described herein comprises:
polarizing the bit lines to a polarization voltage, such polarization voltage being higher than a threshold voltage related to the plurality of respective transistors;
clamping such bit lines at such threshold voltage via such pair of additional control word lines; and
polarizing the word lines to a reading voltage, such reading voltage being higher than the polarization voltage.

Thus, solutions as described herein facilitate obtaining PCM memories with a reading access time related to the exiting from low power mode, the power on of the PCM, the switching on of the regulator, and/or the like, equal to the reading access time obtained during the normal operation of the PCM and the regulator, thus, improving the reading access time of the PCM, avoiding to wait for an unpredictable time during such read operations.

Without prejudice to the underlying principles, the details and the embodiments may vary, even significantly, with respect to what has been described by way of example only without departing from the scope of the embodiments.

The extent of protection is determined by the annexed claims.

## Claims

1. A method of performing bit line initializations in a Phase Change Memory, PCM device, the PCM device comprising:
a plurality of cells (100) selectable via a plurality of respective transistors, preferably bipolar transistors, said plurality of cells (100) being arranged in bit lines (BL) and word lines (WL), and
a pair of additional control word lines (WL_CLAMP_EVEN; WL_CLAMP_ODD),
wherein the method comprises:
polarizing the bit lines (BL) to a polarization voltage (INT_V), said polarization voltage (INT_V) being higher than a threshold voltage (V_{Th}) of the plurality of respective transistors;
clamping said bit lines (BL) at said threshold voltage (V_{Th}) via said pair of additional control word lines (WL_CLAMP_EVEN; WL_CLAMP_ODD); and
polarizing the word lines (WL) to a reading voltage (VBL), said reading voltage (VBL) being higher than the polarization voltage (INT_V).

2. The method according to claim 1, wherein said method is performed at:
a power on of the PCM device;
the PCM device exiting a low power mode; and/or
a switching on of a generator of the reading voltage (VBL);
wherein said method is preferably performed without impacting execution time of:
said power on of the PCM device;
the PCM device exiting said low power mode; and/or
said switching on of the generator of the reading voltage (VBL).

3. The method according to claim 1 or claim 2, wherein said bit lines (BL) are coupled to a main bit line (MBLₖ) via a second plurality of transistors (M).

4. The method according to claim 3, wherein
said second plurality of transistors (M) is configured to be driven via respective control terminals by a first plurality of drivers (D_{YO}) based on a first plurality of driver control signals (E_YO);
said second plurality of transistors (M) is configured to be made conductive by said first plurality of drivers (D_{YO}) in response to said plurality of driver control signals (E_YO) indicating to switch on said second plurality of transistors (M); and
said second plurality of transistors (M) is configured to be made non-conductive by said first plurality of drivers (D_{YO}) in response to said plurality of driver control signals (E_YO) indicating to switch off said second plurality of transistors (M).

5. The method according to claim 4, wherein said first plurality of drivers (D_{YO}) is configured to be coupled via a decoding switch (S₄, S_YO) to a first terminal supplied with the polarization voltage (INT_V),
wherein, preferably, said first plurality of drivers (D_{YO}) is configured to be coupled to a second terminal at the reading voltage (VBL) via the decoding switch (S4, S_YO) in response to said polarizing the word lines (WL) to the reading voltage (VBL),
wherein, preferably, said decoding switch (S4, S_YO) is implemented via a single switch (S 1, S2, S3, S4) configured to be coupled with either the first terminal supplied with the polarization voltage (INT_V) or the second terminal supplied with the reading voltage (VBL).

6. The method according to any of claims 3 to 5, wherein, in response to said polarizing the word lines (WL) to a reading voltage (VBL), the main bit line (MBLₖ) is polarized to said reading voltage (VBL).

7. The method according to any of claims 3 to 6, wherein said polarizing the bit lines (BL) to the polarization voltage (INT_V) comprises:
polarizing the word lines (WL) to the polarization voltage (INT_V);
polarizing the pair of additional control word lines (WL_CLAMP_EVEN; WL_CLAMP_ODD) to the polarization voltage (INT_V);
polarizing the main bit line (MBLₖ) to the polarization voltage (INT_V); and
making said second plurality of transistors (M) conductive.

8. The method according to claim 6 or claim 7, wherein said polarizing the main bit line (MBLₖ) is performed via:
a first transistor (M₁) coupled between the main bit line (MBLₖ) and a first transistor switch (S₁), said first transistor (M₁) being configured to be driven via its control terminal by a first transistor driver (D_{YN1}) based on a first transistor driver control signal (E_MBL_{P}); and
a second transistor (M₂) coupled between the main bit line (MBLₖ) and a sense amplifier (SA), said second transistor (M₂) being configured to be driven via its control terminal by a second transistor driver (D_{YN2}) based on a second transistor driver control signal (E_YNₖ);
wherein:
said second transistor (M₂) is made non-conductive by said second transistor driver (D_{YN2}) in response to said second transistor driver control signal (E_YNₖ) indicating to switch off said second transistor (M₂);
said first transistor (M₁) is made conductive by said first transistor driver (D_{YN1}) in response to said first transistor driver control signal (E_MBL_{P}) indicating to switch on said first transistor (M₁);
if the main bit line (MBLₖ) is to be polarized to the polarization voltage (INT_V), said first transistor driver (D_{YN1}) and said second transistor driver (D_{YN2}) are coupled, via a second transistor switch (S₂, S_YN), to a first terminal supplied with said polarization voltage (INT_V) and said first transistor (M₁) is coupled, via said first transistor switch (S₁, S_MBL_{P}), to said first terminal supplied with said polarization voltage (INT_V); and
if the main bit line (MBLₖ) is to be polarized to the reading voltage (VBL), said first transistor driver (D_{YN1}) and said second transistor driver (D_{YN2}) are coupled, via the second transistor switch (S₂, S_YN), to a second terminal supplied with said reading voltage (VBL) and said first transistor (M₁) is coupled, via said first transistor switch (S₁, S_MBL_{P}), to said second terminal supplied with said reading voltage (VBL),
wherein, preferably, said first transistor switch (S₁, S_MBL_{P}) and said second transistor switch (S₂, S_YN) are implemented via a single switch (S1, S2, S3, S4) configured to be coupled with either the first terminal supplied with the polarization voltage (INT_V) or the second terminal supplied with the reading voltage (VBL).

9. The method according to any of claims 3 to 8, wherein said clamping said bit lines (BL) at said threshold voltage (V_{Th}) comprises:
making said second plurality of transistors (M) non-conductive; and
polarizing said pair of additional control word lines (WL_CLAMP_EVEN; WL_CLAMP_ODD) to a ground voltage.

10. The method according to claim 7, claim 8 in combination with claim 7, or claim 9, wherein said polarizing the pair of additional control word lines (WL_CLAMP_EVEN; WL_CLAMP_ODD) is performed via a second plurality of drivers (D_{WL_E}, D_{WL}__{O}) based on a second plurality of driver control signals (E_WL_EVEN, E_WL_ODD).

11. The method according to claim 10, wherein
if the pair of additional control word lines (WL_CLAMP_EVEN; WL_CLAMP_ODD) is to be polarized to the polarization voltage (INT_V), said second plurality of drivers (D_{WL_E}, D_{WL_O}):
is coupled, via a word line switch (S₃, S_WL), to a first terminal supplied with said polarization voltage (INT_V), and
is disabled in response to said second plurality of driver control signals (E_WL_EVEN, E_WL_ODD) indicating to switch off said pair of additional control word lines (WL_CLAMP_EVEN; WL_CLAMP_ODD); and
if the pair of additional control word lines (WL_CLAMP_EVEN; WL_CLAMP_ODD) is to be polarized to a ground voltage, said second plurality of drivers (D_{WL_E}, D_{WL}__{O}) is enabled in response to said second plurality of driver control signals (E_WL_EVEN, E_WL_ODD) indicating to switch on said pair of additional control word lines (WL_CLAMP_EVEN; WL_CLAMP_ODD),
wherein, preferably, said word line switch (S₃, S_WL) is implemented via a single switch (S 1, S2, S3, S4) configured to be coupled with either the first terminal supplied with the polarization voltage (INT_V) or a second terminal supplied with the reading voltage (VBL).

12. The method according to any of the previous claims, wherein said polarizing the word lines (WL) is performed via a third plurality of drivers (D_{WLj-1}, D_{WLj}, D_{WLj+1}) based on a third plurality of driver control signals (E_WLⱼ₋₁, E_WLⱼ, E_WLⱼ₊₁).

13. The method according to claim 12, wherein
if the word lines (WL) are to be polarized to the polarization voltage (INT_V), said third plurality of drivers (D_{WLj-1}, D_{WLj}, D_{WLj+1}):
is coupled, via a word line switch (S₃, S_WL), to a first terminal supplied with said polarization voltage (INT_V), and
is disabled in response to said third plurality of driver control signals (E WLⱼ₋₁, E_WLⱼ, E_WLⱼ₊₁) indicating to switch off said word lines (WL); and
if the word lines (WL) are to be polarized to the reading voltage (VBL), said third plurality of drivers (D_{WLj-1}, D_{WLj}, D_{WLj+1}):
is coupled, via the word line switch (S₃, S_WL), to a second terminal supplied with said reading voltage (VBL), and
is disabled in response to said third plurality of driver control signals (E WLⱼ₋₁, E_WLⱼ, E_WLⱼ₊₁) indicating to switch off said word lines (WL),
wherein, preferably, said word line switch (S₃, S_WL) is implemented via a single switch (S 1, S2, S3, S4) configured to be coupled with either the first terminal supplied with the polarization voltage (INT_V) or the second terminal supplied with the reading voltage (VBL).

14. A Phase Change Memory, PCM device, the PCM device comprising:
a plurality of cells (100) selectable via a plurality of respective transistors, said plurality of cells (100) being arranged in bit lines (BL) and word lines (WL), and
a pair of additional control word lines (WL_CLAMP_EVEN; WL_CLAMP_ODD);
said PCM device being configured to implement the method according to any of claims 1 to 13.

15. A computer program product loadable in a control unit of a Phase Change Memory, PCM device, the PCM device comprising:
a plurality of cells (100) selectable via a plurality of respective transistors, said plurality of cells (100) being arranged in bit lines (BL) and word lines (WL), and
a pair of additional control word lines (WL_CLAMP_EVEN; WL_CLAMP_ODD);
the computer program product comprising portions of software code configured to cause the PCM device to implement the method according to any of claims 1 to 13 in response to the computer program product being run in the control unit of the PCM device.
